# EUROPEAN PATENT SPECIFICATION

(11) **EP 0 823 491 B1**
(45) Date of publication and mention of the grant of the patent: **27.02.2002**
(21) Application number: 97305982.7
(22) Date of filing: 06.08.1997
(51) Int. Cl.: C23C 16/44, H01L 21/00

(54) **Gas injection system for CVD reactors**
Gaseinleitsystem für CVD Reaktoren
Système d'injection de gaz pour réacteurs CVD

(30) Priority: 07.08.1996 US 693721; 16.06.1997 US 876967
(43) Date of publication of application: 11.02.1998
(73) Proprietor: Concept Systems Design Inc., Fremont, California 94538 (US)
(72) Inventor: Macleish, Joseph H, San Ramon, CA 94583 (US); Mailho, Robert D, Sonora, CA 95370 (US); Sanganeria, Mahesh K, Sunnyvale, CA 94086 (US); Del Solar, Enrique Suarez, Oakland, CA 94602 (US)
(74) Representative: Atkinson, Ralph

(56) References cited:
- EP-A- 0 254 651
- EP-A- 0 480 181
- EP-A- 0 675 524
- US-A- 5 338 363

## Description

The present invention relates to a chemical vapour deposition (CVD) process chamber and, specifically, to a single wafer, multi-chamber CVD system.

A continuing challenge in the fabrication of integrated circuits is to maintain a wafer at a constant and uniform temperature so that various layers (ie, epitaxial layers, polysilicon layers, etc) of a uniform thickness and resistivity may be deposited thereon. In a typical radiantly heated "warm" wall CVD reactor, a wafer is placed in a quartz containment vessel. As the vessel and the wafer therein are heated by lamps positioned external to the vessel, process or reactant gases are pumped into the vessel so as to deposit on the wafer.

Warm wall CVD reactors, such as the one described above, have a number of limitations which adversely affect efficiency, reliability, and performance. For single wafer CVD systems, including those tailored to deposit epitaxial and polysilicon layers, throughput is an important consideration. Perhaps the biggest obstacle to improving throughput in such CVD systems is the time required to clean the chamber walls after each wafer is processed. Cleaning the chamber walls in radiantly heated quartz CVD chambers is vital since process gases deposit on the chamber walls at an increasing rate, thereby creating a "snowball" effect. It is therefore critical, in a radiantly heated CVD chamber, that the walls be kept meticulously clean. This requires that the walls be etched frequently, sometimes even after every run. Cleaning the walls typically takes between two to three-and-a-half minutes after depositing an epitaxial layer, and up to one hour after depositing polysilicon used in sealing the backside of silicon wafers. Such long cleaning times result from the relatively slow etchant rates associated with the warm walls of the chamber (which are designed to transmit heat). Since the entire cycle time in warm wall CVD systems may be between five to ten minutes, cleaning the walls accounts for a significant portion of the cycle time.

Another factor affecting the throughput of such CVD chambers is the deposition rate of the process gases. Chambers that are optimised for deposition rates can increase deposition time required for a single wafer by as much as twenty-five percent.

Additionally, lamp failure (and the maintenance related thereto) and a required wet etching of the quartz chamber walls of such CVD systems adversely affect reliability and uptime. Note that wet etching requires disassembling the CVD system so that the quartz walls may be submerged in a wet etch bath.

Temperature control of the wafer is imperative for the deposition of uniform layers. The above described deposition of process gases on the chamber walls of lamp heated systems can occur within a single run and may affect the temperature uniformity within a run. Thus, cleaning the chamber walls after each wafer run may be ineffective in preventing nonuniformities resulting from deposition of process gases on the chamber walls.

Achieving a constant and uniform temperature across a wafer is further complicated by variations in the emissivity of the wafer. Since a wafer's emissivity depends in part upon the surface material of the wafer and upon temperature, accurately calibrating a reactor so as to bring the wafer to a constant and uniform temperature may be difficult.

An optimum CVD system should be able to operate at both atmospheric and reduced pressures. Reduced pressure operation requires a chamber design able to withstand the physical stresses of a lower pressure processing environment, ie, a vacuum chamber. On the other hand, optimum designs for wafer processing may require a process gas flow channel having a narrow profile. This narrow profile optimises process gas flow to the wafer by facilitating a maximum velocity flow of process gas across the wafer while minimising the mass transfer boundary layer. In addition to having a narrow profile, chambers designed for optimum processing typically have simple non-convoluted surfaces so as to minimise vortices and backflow, to minimise dead spots that may promote deposition on the chamber walls, and to allow etching gases employed to clean the chamber walls to quickly reach the chamber walls. Unfortunately, such flat-topped quartz or graphite process chambers cannot easily sustain a pressure gradient across their walls. Chambers capable of withstanding such pressure differences typically are either of a fuller shape, such as a bell or globe structure, and therefore not only compromise optimum gas flow across the surface of the wafer but also do not facilitate an efficient cleaning of the chamber walls. Another approach is to incorporate structural reinforcement elements on the chamber walls. Unfortunately, such elements hamper the uniform transmission of radiant energy to the wafer. As a result, single chamber CVD designs suitable for reduced pressure operation typically compromise processing considerations such as process gas flow or thermal uniformity in order to increase structural integrity.

Those disclosed in EP-A-0 254 651 a method in which a first gas is injected from above the wafer while a process gas is introduced horizontally to flow across the surface of the wafer. The stream of reactive gas is redirected by the first gas to flow parallel to the surface of the wafer or substrate under laminar flow conditions.

According to the present invention, a gas injection system for injecting one or more process gases into a reaction chamber within which a wafer is processed, said gas injection system being characterised by: one or more first slots or holes form in a first portion of the bottom surface of said reaction chamber; and one or more second slots or holes formed in a second portion of the bottom surface of said reaction chamber, said one or more second slots or holes being positioned intermediate said one or more first slots or holes and a side wall of said reaction chamber; wherein a first gas is injected into said reaction chamber in a direction toward said wafer through said one or more second slots or holes and said one or more process gases are injected into said reaction chamber through said one or more first slots or holes, said first gas serving to re-direct said one or more process gases into a flow pattern substantially parallel to a top surface of said wafer.

According to the present invention, a method for injecting one or more process gases into a reaction chamber within which a wafer is processed, comprising the steps of: injecting a first gas into said reaction chamber in a direction towards said wafer; injecting said one or more process gases into said reaction chamber from a first bottom portion of said reaction chamber; and re-directing said one or more process gases into a flow pattern substantially parallel to a top surface of said wafer with said first gas.
*Figure 1* is a cross-sectional view of a CVD reactor in accordance with one embodiment of the present invention, where the susceptor is in a lowered position to allow for loading of the wafer;
*Figure 2* is a cross-sectional view of the CVD reactor of *Figure 1* taken from a perspective perpendicular to that of *Figure 1*, where the susceptor is in a raised position to allow for processing of the wafer;
*Figures 3A* and *3B* are cross-sectional views of wafer susceptors in accordance with embodiments of the present invention;
*Figure 4* is a cross-sectional view of a process gas injection system in accordance with the present invention;
*Figures 5* and *6* are top views of respective elements **25** and **26** of the reactor of *Figures 1* and *2*;
*Figure 7* is a top view of diffuser plate **28b** of *Figure 4*;
*Figure 8* is a graph illustrating the effect of the diffuser plate of *Figure* 7 on epitaxial thickness;
*Figure 9* is a cross-sectional view of reactor **10** illustrating gas flow patterns characteristic thereof;
*Figures 10* and *11* illustrate calculated deposition rates as a function of position on a wafer processed in accordance with the present embodiments;
Figures 12 and 13 are graphs illustrating the effect of varying process gas flow rates on epitaxial thickness;
Figure 14 is a cross sectional view along an axis of a cylindrical reactor in accordance with another embodiment of the present invention; and
Figure 15 is a cross-sectional view along a diameter of the reactor of Figure 14.

Use of the same reference numbers in different figures indicates similar or like elements.

### DETAILED DESCRIPTION

The operation of embodiments of the present invention will be discussed below in the context of the deposition of an epitaxial layer on a wafer. It is to be understood, however, that embodiments in accordance with the present invention may be used to deposit or grow any suitable material, such as polysilicon or gate oxide, respectively, on a wafer while still realizing the advantages of the present invention.

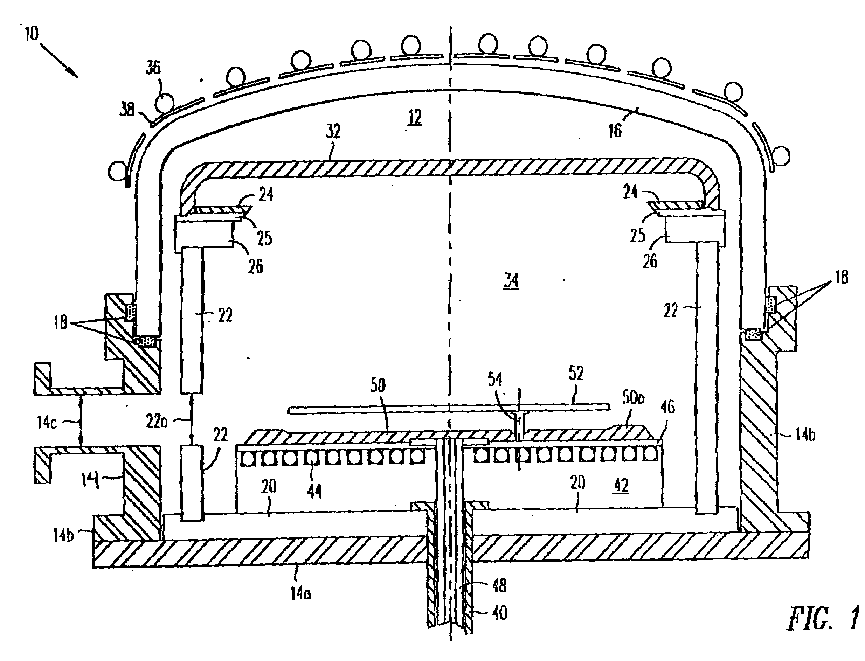

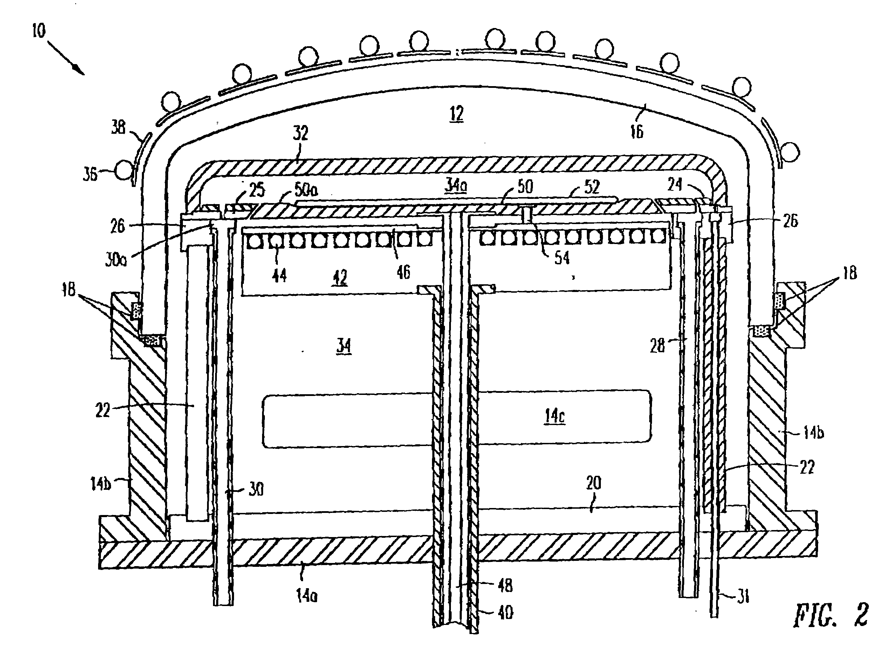

Referring now to Figures 1 and 2, where common parts are denoted with the same numerals, a chemical vapor deposition (CVD) reactor 10 includes a pressure vessel comprised of a bell jar 16 and a stainless steel cylindrical outer housing 14 having a base plate 14a and a side wall 14b. Bell jar 16 is preferably opaque quartz and is removably attached to outer housing 14. Side wall 14b is securely attached to base plate 14a and is attached to and pressure sealed with bell jar 16 via O-rings 18. A quartz plate 20 is mounted onto base plate 14a. The pressure vessel formed by elements 14 and 16 encloses volumes 12 and 34 which can be at a reduced pressure.

A cylindrical inner housing 22 preferably constructed of opaque quartz is positioned within the pressure vessel formed by elements 14 and 16 and mounted onto quartz plate 20. A first ring place 24 preferably made of silicon carbide overlies a second ring plate 25 made of quartz which is mounted onto a spacer ring 26 which, in turn, is mounted onto inner housing 22, as shown in Figure 1. Referring to Figure 2, ring plates 24, 25 and spacer ring 26 each have one or more aligned openings through which one or more associated injection ducts 28 and exhaust ducts 30 pass (only one injection duct 28 and one exhaust duct 30 are shown for simplicity). Additional aligned openings are formed in ring plates 24, 25 and spacer ring 26 through which one or more associated injection ducts 31 pass. A dish 32 is mounted onto the upper surface of second ring plate 25. Dish 32, which is preferably graphite and has a coating of silicon carbide provided on the outer surface thereof, is in intimate contact with second ring plate 25. As shown in Figure 1, aligned openings 14c and 22a formed respectively in outer housing 14 and inner housing 22 allow a mechanical robot arm of well known design (not shown for simplicity) to insert and remove a wafer to and from the interior of reactor 10. A valve (not shown) is provided within opening 14c to isolate the inside of reactor 10 from the environment external to reactor 10.

A plurality of water-cooled, copper induction coils 36 are provided on an outside surface of bell jar 16. The turns of coils 36 may be electrically isolated from one another by non-conductive separators (not shown) such as, for example, quartz or ceramic or any appropriate material or combination of materials having the desired electrical properties. In this manner, coils 36 do not interact with one another. This also minimizes the tendency to arc or form plasmas. Diffusion plates 38 support copper coils 36 and also shape the RF field generated by copper coils 36 and result in a more uniform heating of reactor 10. In the preferred embodiments, induction coils 36 are grouped into three independently controlled concentric heating zones to allow for the uniform heating of a wafer. Of course, a different number of controlled heating zones may be employed if so desired. The temperature of the exterior of copper coils 36 should be kept below the melting point of copper coils 36.

A longitudinal tube 40 preferably made of quartz has an upper end coupled to a circular quartz housing 42 having a plurality of induction coils 44 therein and has a lower end operatively coupled in a conventional manner to an electrically controllable lift motor (not shown) which raises and lowers tube 40 and housing 42. In some embodiments, coils 44 are similar in construction to coils 36. Preferably, coils 44 are grouped in three independently controllable concentric heating zones, although a different number of controllable heating zones may be used if desired, and are electrically isolated from one another in a manner similar to that described above with respect to coils 36. A silicon carbide layer 46 provided on the top surface of housing 42 serves as a heat conductor between coils 44 and a circular graphite susceptor 50.

Positioned within tube 40 is a rotatable quartz longitudinal shaft 48 having an upper end coupled to susceptor 50 upon which a wafer 52 to be processed rests. The lower end of shaft 48 is operatively coupled in a conventional manner to an electrically controllable drive motor (not shown) which allows for susceptor 50, and thus wafer 52, to be raised, lowered, and rotated. Concentric tube 40 and shaft 48 pass through housing 42 via a circular opening at the center thereof.

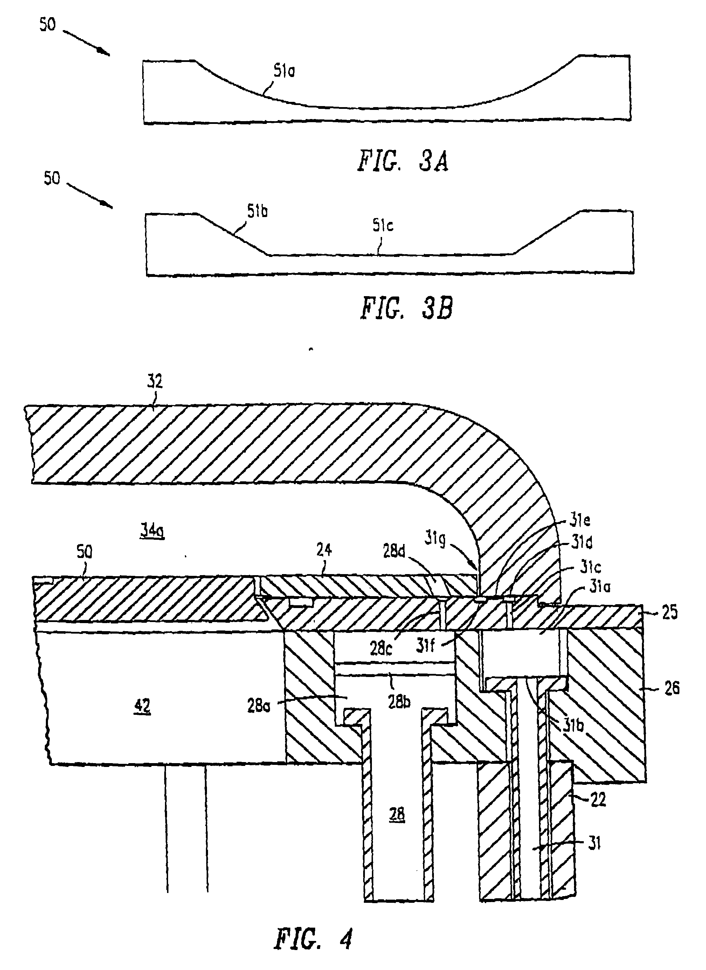

A portion of the top surface of susceptor 50 is recessed such that a minimum number of points along the outer edge of wafer 52 need be in intimate contact with susceptor 50 while wafer 52 rests thereon, thereby minimizing conductive heat transfer between susceptor 50 and wafer 52. In some embodiments, susceptor 50 has a dish-shaped cavity 51a formed therein, as shown in Figure 3A, while in other embodiments the recessed portion of susceptor 50 preferably has an angled wall 51b sloping down to a linear recessed surface 51c, as shown in Figure 3B. The susceptor shown in Figure 3B is preferred since linear surface 51c allows for a more uniform spacing between susceptor 50 and a wafer than does the dish-shaped cavity 51a of susceptor 50 shown in Figure 3A.

When resting on susceptor 50 as shown in Figure 2, the bottom surface of wafer 52 is approximately 3-5 mils above the top surface of susceptor 50. The top surface of wafer 52 should be substantially flush with the top surface of the outer lip 50a of susceptor 50. For example, in some embodiments the top surface of wafer 52 can be within ±80 mills of the top surface of outer lip 50a of susceptor 50 and can be considered substantially flush. Susceptor 50 has three openings formed therein through which three quartz or silicon carbide pins 54 protrude so as to, when desired, lift wafer 52 off susceptor 50 (only one of pins 54 is shown in Figure 1 for simplicity).

Wafer 52 is loaded onto pins 54 via a mechanical robot (not shown) through openings 14c and 22a. The lift motor is operated to raise shaft 48 and susceptor 50. Susceptor 50 gently lifts wafer 52 off pins 54 and cradles wafer 52 in its recessed portion as described earlier with respect to Figures 3A and 3B. As the lift motor operation continues, houaing 42 rises along with shaft 48 and susceptor 50. In this manner, wafer 52, susceptor 50 and housing 42 are elevated into the processing position shown in Figure 2.

The top surface of ring plate 24 and the top surface of lip 50a of susceptor 50 should be in substantially the same plane. While some deviation in this co-planarity might be expected, the goal is to make these two surfaces as closely as possible in the same plane. In this manner, dish 32, ring plate 24, susceptor 50 and wafer 52 form a parallel-plate shaped reaction chamber 34a that approximates a black body cavity and, thus, minimizes temperature gradients across wafer 52. Chamber 34a isolates process or reactant gases used in processing wafer 52 from the pressure vessel while allowing pressure equalization between the pressure vessel and reaction chamber 34a. In some embodiments, a venturi-type system is used to control the pressure in chamber 34a independent of wafer fab facility scrubber pressures, thereby allowing specific types of wafer processing to be repeatable without varying scrubber or outside pressures. The venturi injects nitrogen into an exhaust (not shown). As the pressure changes in chamber 34a, nitrogen feed pressure to the venturi is adjusted to maintain the desired pressure.

Power is applied to induction coils 36 (Figures 1 and 2) along the outer surface of bell jar 16 and to induction coils 44 disposed within housing 42 to heat wafer 52 to a desired temperature. The RF energy emitted from coils 36 couples to dish 32 and is controlled to create a uniform temperature across dish 32, thereby heating wafer 52 from above. In a similar manner, RF energy emitted by coils 44 in housing 42 couples with susceptor 50, thereby heating wafer 52 from below. In one embodiment, three infrared (IR) sensors (not shown) arranged in a linear fashion outside and about the periphery of bell jar 16 are employed to determine the temperature of portions of dish 32 immediately above wafer 52 through three associated clear quartz windows (not shown) in bell jar 16. Three sets of aligned quartz windows (not shown) may be formed in housing 42 and layer 46 so that additional IR sensors positioned below base place 14a may be employed to measure the temperature of portions of susceptor 50 immediately below wafer 52. Suitable IR sensors are commercially available from LAND Corporation of Bristol, Pennsylvania. Although IR sensors are preferred, other sensors may be employed herein without departing from the scope of the present invention.

Information indicative of temperature gradients across wafer 52 generated by the three IR sensors above wafer 52 is provided as feedback to a controller (not shown) which in response thereto adjusts the RF fields generated by each of the three independently controlled concentric zones of coils 36. In some embodiments, this controller may be a computer. In a similar manner, information indicative of temperature gradients across wafer 52 generated by the three IR sensors below wafer 52 is used by the controller (not shown) to adjust the RF fields generated by each of the three independently controlled zones of coils 44. In this manner, reactor 10 maintains wafer 52 at a controlled and uniform temperature. Note that in other embodiments, independently controllable concentric zones of coils 36 and coils 44 may be replaced by radiant energy sources, such as for instance conventional heat lamps.

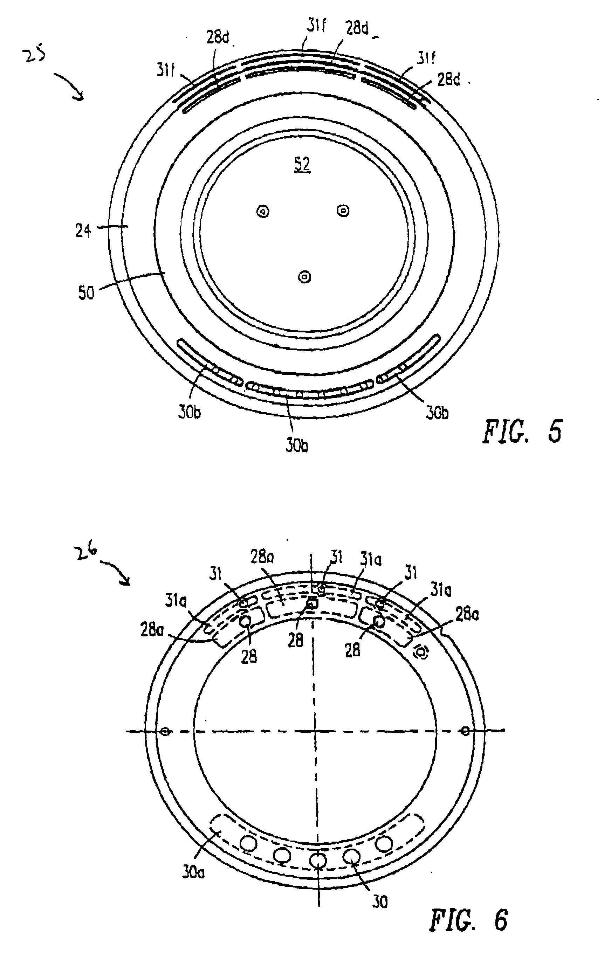

Process gases are fed into reaction chamber 34a via three injection ducts 28 (only one shown in Figure 2 for simplicity). In other embodiments, reactor 10 may include a greater or fewer number of such injection ducts 28. Referring also to Figure 4 which shows in detail that portion of one of injection ducts 28 lying within spacer ring 26 and to Figures 5 and 6 which show cross-sectional views of elements **25** and **26**, respectively, each of injection ducts **28** is connected to an associated injection plenum **28a** formed within spacer ring **26**. Spacer ring **26**, which is preferably quartz, is heated as housing **42**, dish **32**, and susceptor **50** are heated by coils **36** and **44,** as described above. As a result, process gases passing through injection ducts **28** and plenum **28a** within spacer ring **26** are heated (typically between seven hundred degrees centigrade and nine hundred degrees centigrade) prior to entering reaction chamber **34a**, with spacer ring **26** acting as a heating source. Because the process gases are pre-heated, problems caused when cool gases contact a wafer, such as non-uniform deposition of material on wafer **52**, are eliminated, and a more uniform depositoin is attainable.

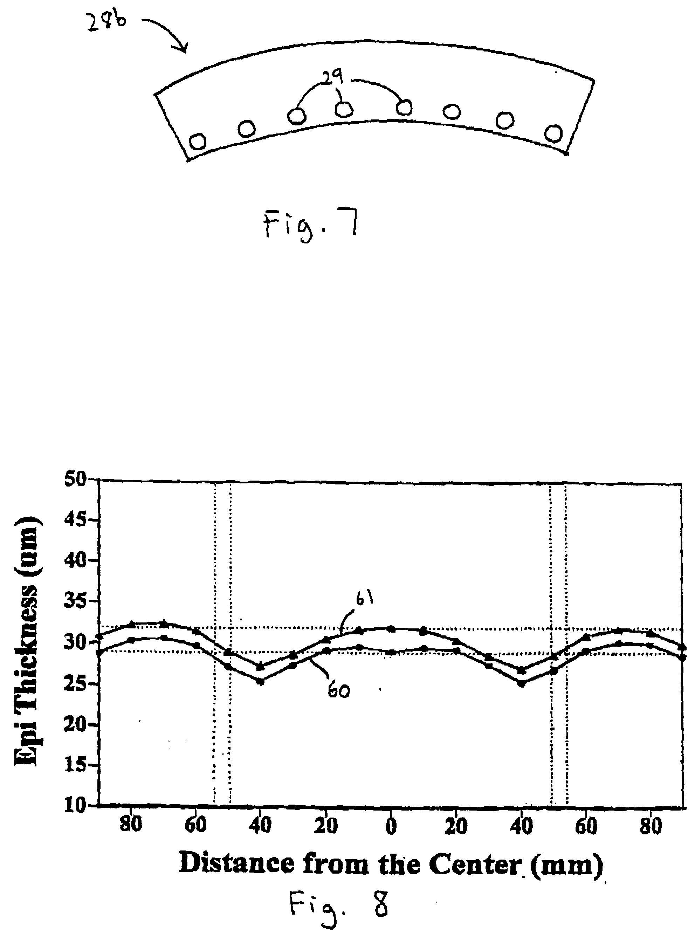

Furthermore, plenum **28a** contains a diffuser plate **28b** having, in one embodiment, eight 0.10 centimetres (0.04 inches) holes **29,** formed therein, as shown in *Figure 7*. The size and number of holes **29** within diffuser plate **28b** may vary depending upon desired gas flow characteristics. If the size of holes **29** are decreased process gases passing through injection ducts **28** and plenum **28a** are more highly diffused prior to entry into reaction chamber **34a** via slots **28c** and **28d.** As a result, the process gases are spread more uniformly throughout the plenum before entry into reaction chamber **34a**, thereby allowing more uniform deposition on the wafer. In addition, by decreasing the number of holes **29**, diffusion of process gases through diffuser plate **28b** can be further increased. As high velocity process gases flow in a vertical direction through duct **28** and into plenum **28a,** the process gases strike the bottom surface of diffuser plate **28b** and are both slowed and diffused as they flow through plenum **28a** and into reaction chamber **34a.** The result is a more uniform epitaxial deposition across the centre of the wafer, as shown in *Figure 8,* which also shows that as process gases become more highly diffused, the epitaxial thickness becomes more uniform. Curve **60** represents the effect of a diffuser plate which diffuses the gases more than a diffuser plate of curve **61.** In *Figure 8,* the process gas flow rates are 20 L/min for each of the two slots (**28d**_{**1**} and **28d**_{**3**} in *Figure 5*) associated with an outer portion of wafer **52** and 33 L/min for the slot (**28d**_{**2**} in *Figure 5)* associated with an inner portion of wafer **52,** the outer and inner portions defined by the dotted lines in *Figure 8.*

After entering the upper portion of plenum **28a** via the holes formed in diffuser plate **28b**, the process gases pass through connected vertical slot **28c** and angled slot **28d** and flow into reaction chamber **34a** at some predetermined angle which is chosen to maximise uniform deposition of a selected material upon wafer **52**. In some embodiments, slots **28c** and **28d** have a width of approximately one centimetre (10 millimetres), while in other embodiments slots **28c** and **28d** may be replaced by a series of adjacent holes or other appropriate structure. In general, slots **28c** and **28d** are of the same shape, but slot **28d** is typically wider. Also note that, as shown in *Figures 5* and *6*, each of plenums **28a** and associated slots **28c** and **28d** may be of differing dimensions as required by the desired particular process gas flow characteristics. Changing the slot length changes the area of the wafer covered, and the slot size can be optimised for uniform deposition. In all of the present embodiments, the goal is for the above-described series of holes and slots to create sufficient back pressure so that the process gases forced into reaction chamber **34a** have an even, lateral distribution around the interior periphery of chamber **34a.**

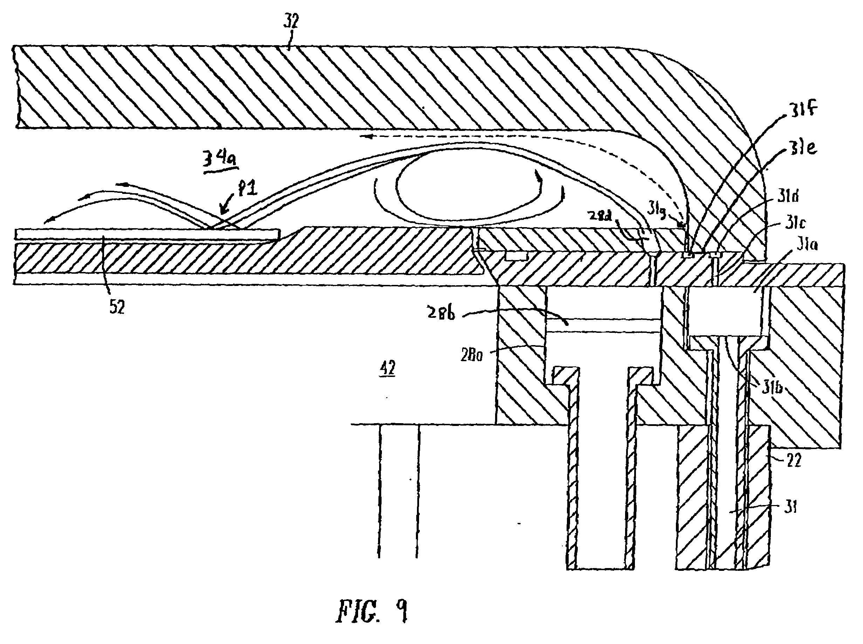

Referring to *Figure 9,* during processing of wafer **52,** hydrogen or any appropriate gas is pumped into reaction chamber **34a** via three injection ducts **31** (only one shown for simplicity) lying within associated bore holes formed in housing **22.** Each of ducts **31** is connected to an associated plenum **31a** via a hole **31b** formed within a bottom surface of plenum **31a.** The hydrogen or other appropriate gas is partially diffused upon entering plenum **31a** and is forced into a vertical channel **31c** formed in second ring plate **25** and having a width of approximately 0.10 centimetres (0.04 inches). The gas enters a first chamber **31d**, passes through a horizontal channel **31e,** and enters a second chamber **31f.** The gas is forced from second chamber **31f** into reaction chamber **34a** via a vertical gap **31g** between ring plate **24** and dish **32.** In other embodiments, gap **31g** is non-vertical and directed towards wafer **52** at an angle less than ninety degrees from horizontal. Note that the precise dimensions of each of elements **31a** to **31g** may vary depending upon desired process gas flow characteristics.

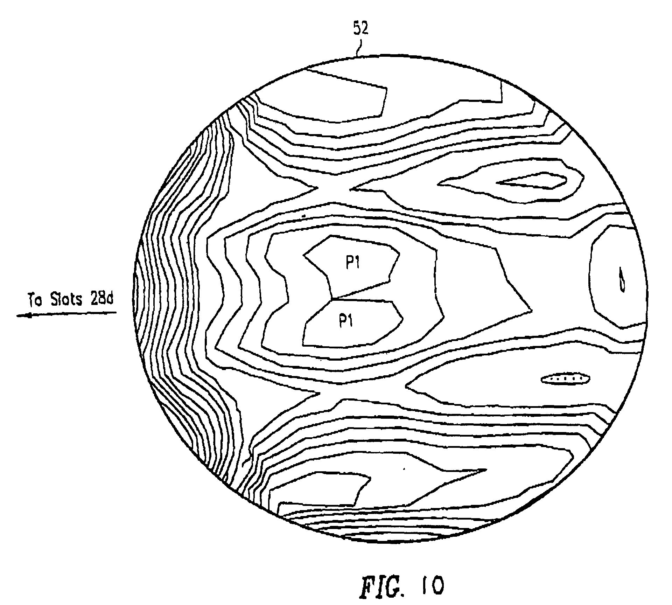

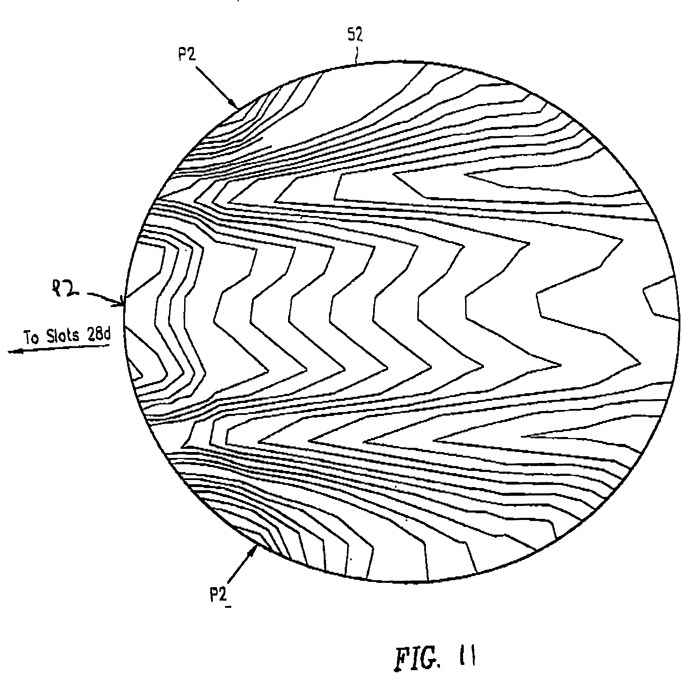

The flow of hydrogen or other appropriate gas interposed between the flow of process gases and dish **32** causes the flow of process gases from slots **28d** to "turn over", as shown in *Figure 9*, so as to flow through reaction chamber **34a** parallel to the top surface of wafer **52.** In *Figure 9,* the gas flow of process gases is indicated in solid lines while the gas flow of hydrogen (or other appropriate gas) is indicated in dashed lines. Thus, the process gases enter reaction chamber at some predetermined angle and turn over so as to result in a maximum deposition on wafer **52** at a point P1. The process gas flow then evens out into a substantially horizontal gas flow across the top surface of wafer **52.** This maximum deposition point P1 may be moved relative to the surface of wafer **52** by adjusting the flow rate of the hydrogen or other appropriate gas emitted from gap 31g, where increasing the flow rate of the hydrogen (or other appropriate gas) results in the maximum deposition point P1 being moved towards slot 28d. The deposition pattern may also be controlled by changing the angle of slots 28d. By way of example, Figures 10 and 11 illustrate the calculated deposition rate of the process gases as a function of position on wafer 52 under different operating conditions, where the contour lines represent equal deposition rates. In Figure 10, hydrogen gas flows into reaction chamber 34a from gap 31g at a rate of approximately 10 L/min. The maximum deposition occurs in the two adjacent zones P1 in the center of wafer 52, where the deposition rate decreases when moving from the inner portions of wafer 52 to the periphery of wafer 52. In Figure 11, hydrogen gas flows into reaction chamber 34a from gap 31g at a race of approximately 70 L/min. In this case, maximum deposition occurs in zones P2 and generally decreases when moving across wafer 52 away from slots 28d. Note that the difference between the deposition patterns shown in Figures 10 and 11 is due to the difference in flow rates of the hydrogen gas, where increasing the flow rate of the hydrogen gas moves the recirculation flow towards slots 28d. Furthermore, by controlling the hydrogen gas flow rates individually for each of the three gaps 31g, the point of maximum deposition rate can be moved in three different zones.

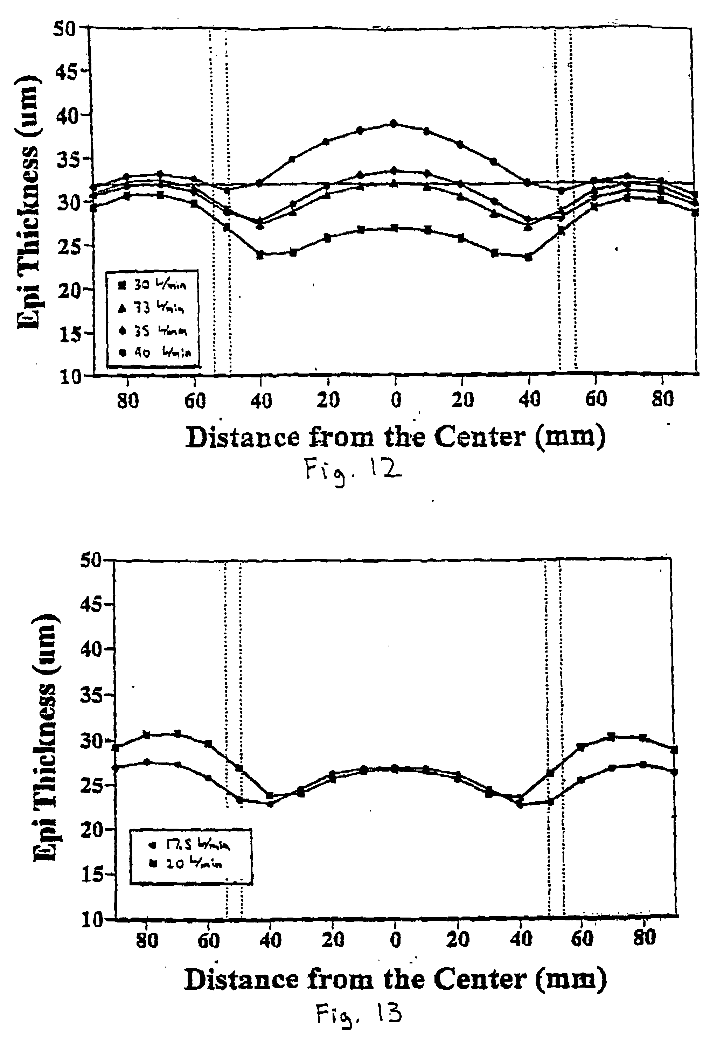

In addition to adjusting the hydrogen gas flow rates, the process gas flow rates from each of slots 28d can also be modified individually to change the deposition race across different portions of wafer 52. By increasing the flow rate in the center one of slots 28d (slot 28d₂ in Figure 5) while keeping the flow rates in the outer ones of slots 28d (slots 28d₁ and 28d₃ in Figure 5) constant, deposition rates in a center portion of wafer 52 can be increased, similarly, by increasing the flow rates in outer slots 28d₁ and 28d₃ while keeping the flow rate in center slot 28d₂ constant, deposition rates in outer portions of wafer 52 can be increased. Figures 12 and 13, based on measured experimental data, show that the thickness of a silicon epitaxial layer on the center and outer portions of a wafer can be adjusted by changing process gas flow rates in the center and outer ones of slots 28d, respectively. In Figure 12, the flow rate of process gas in each of the outer ones of slots 28d is kept constant at 20 L/min, while in Figure 13, the flow rate of process gas in the center one of slots 28d is maintained at 30 L/min. Process gases include hydrogen with a silicon source (i.e., trichlorosilane, dichlorosilane, or silane) and a dopant gas (i.e., diborane, phosphine or arsine). In both cases, susceptor 50 is heated to 1100°C and dish 32 is heated to 1180°C for 8 minutes of epitaxial deposition on a 200 mm diameter wafer.

The compact gas injection system described above allows process gases to be evenly distributed close to the surface of wafer 52 without requiring a long entry channel in reaction chamber 34a, thereby allowing reaction chamber 34a to be more compact without adversely affecting desired gas flow characteristics. Also note that none of the above elements which facilitate gas flow into reaction chamber 34a, such as ring plate 25, spacer ring 26, and injection ducts 28 and 31, protrude into heated portions of reaction chamber 34a where film deposition may occur, thereby preventing unwanted film deposition thereon. Further, the flow of hydrogen gas into reaction chamber 34a from injection duct 31 minimizes unwanted deposition of the material being deposited on wafer 52 on interior surfaces of dish 32. In preferred embodiments, gas flow rates are controlled so that the location of the maximum deposition rate, e.g. zones P1 or P2, counters any reactant depletion effect on wafer 52. In this manner, the rotation of wafer 52 may result in uniform deposition rates across the surface of wafer 52.

This gas injection system is in marked contrast to conventional CVD reactors such as those available from Applied Material and ASM in which the process gases are introduced in a horizontal flow pattern from the side of the chamber. such conventional systems therefore require a long entry channel to achieve a uniform gas flow distribution across the chamber. Further, the long entry channel in these systems is typically within the heated portion of the chamber, thereby resulting in additional unwanted deposition upon interior surfaces of the chamber. Embodiments of this invention, on the other hand, allow for process gases to enter reaction chamber 34a at some predetermined angle through gap 28d. Dish 32, together with the flow of hydrogen or appropriate gas from gap 31g, redirects the process gas flow to substantially horizontal. In this manner, a uniform flow of process gases across the surface of wafer 52 is ensured while advantageously minimizing the entry length.

During processing, the drive motor causes wafer 52 to rotate, usually at speeds between 10 and 40 rpm. Referring back to Figures 2, 5, and 6, process gases are removed from reaction chamber 34a by flowing into a plurality of slots 30b which are connected to exhaust plenums 30a. Each of exhaust plenums 30a is connected to an associated exhaust tube 30. Of course, in other embodiments reactor 10 may employ different exhaust mechanisms, including employing a greater or fewer number of exhaust plenums 30a. The remaining portion of chamber 34 which lies substantially below housing 42 may be purged of process gases leaking thereto from reaction chamber 34a using for instance hydrogen or HCl gas. Hydrogen is compatible with suitable process gases and HCl is effective in removing process gas depositions from areas of chamber 34 lying substantially underneath housing 42.

Reactor 10 processes wafers at temperatures which may exceed approximately 1100°C. Applicants have determined that in order to avoid slip when removing wafer 52 from reactor 10, the wafer 52 should be cooled in a controlled and uniform manner to between approximately 750-950°C before the mechanical arm (not shown) removes wafer 52 through openings 14c and 22a. since the throughput of reactor 10 is affected by the time required to cool wafer 52 from approximately 1100°C or higher to approximately 800°C, it is advantageous to cool wafer 52 as quickly as possible in a uniform manner.

Immediately after processing wafer 52 in reaction chamber 34a, dish 32, wafer 52 and susceptor 50 are at approximately the same temperature, i.e., the reaction temperature. Power applied to coils 36 is maintained such that the temperature of dish 32 remains at the reaction temperature. The drive motor is activated to lower housing 42 and susceptor 50, respectively, towards quartz plate 20. As housing 42 and susceptor 50 are lowered away from dish 32, wafer 52 begins to cool. Since the rate of heat radiation or loss increases when moving radially outward from the center to the outer periphery of wafer 52, power levels applied to the three independently controllable concentric zones of coils 44 are manipulated to compensate for this non-uniform heat loss by causing susceptor 50 to transfer more heat from its outer portions than from its inner portions, thereby facilitating a uniform cooling of wafer 52. As the temperature of wafer 52 approaches approximately 800°C, slip problems become much less significant. As susceptor 50 nears the bottom of chamber 34, power to coils 44 is reduced, and susceptor 50 is brought into intimate contact with silicon carbide layer 46 of housing 42. Housing 42 has formed therein three holes (not shown) into which pins 54 slide as susceptor 50 is brought into intimate contact with housing 42 so that wafer 52 rests on susceptor 50 while susceptor 50 is in intimate contact with layer 46.

During this cooling process, heat is conductively transferred from wafer 52 to susceptor 50, which in turn conductively transfers heat to layer 46 of housing 42. Layer 46 disperses heat therefrom to water circulating within coils 44. In this manner, wafer 52 may be cooled from a reaction temperature of approximately 1100°C to approximately 800°C in less than 1 minute. Conventional control algorithms may be employed to ensure that power provided to each of the zones of coils 36 and 44 is managed in a manner so as to result in raising and lowering the temperature of wafer 52 uniformly across the wafer from the center to its outer periphery, maintaining wafer 52 at a constant and uniform temperature during processing, and cooling wafer 52 in a uniform manner.

When the temperature of wafer 52 reaches approximately 800°C, susceptor 50 is raised a sufficient distance so as to engage and lift pins 54 out of their associated holes formed in housing 42. Susceptor 50 is then rotated so that pins 54 are no longer aligned with their associated holes formed in housing 42 and then lowered into intimate contact with layer 46. The lower ends of pins 54 engage the top surface of layer 46 of housing 42 and thereby lift wafer 52 off susceptor 50, as shown in Figure 1. The temperature of susceptor 50 is not allowed to fall below approximately 800°C, and dish 32 is maintained at the reaction temperature even when reloading wafers. By maintaining internal components of reactor 10 at predetermined minimum temperatures, the amount of heat required to bring these components back up to the reaction temperature is advantageously minimized, thereby saving valuable time and energy.

In preferred embodiments, wafers to be processed in reactor 10 are first processed in a pre-clean chamber (not shown). The native oxide on the surface of the wafer may be removed in the pre-clean chamber in less than approximately one minute. In some embodiments, this pre-clean chamber is configured co feed two of reactors 10. The pre-clean chamber may operate at lower temperatures so as to minimize the thermal budget associated therewith. After cleaning, the wafers are then transferred from the pre-clean chamber to one of reactors 10 via an isolated transfer chamber (not shown) by a robotic arm (not shown).

This separate pre-cleaning chamber structure is in marked contrast to conventional techniques in which the process chamber of the CVD reactor is used for both cleaning the native oxide off the wafer and for wafer processing i.e. the deposition of films onto the wafer. In cleaning the wafer in such conventional systems, the chamber and wafer are brought to a high temperature such as for instance 1160° or higher. Hydrogen gas is pumped into the chamber and reacts with the native oxide on the wafer surface and thereby removes the native oxide. The temperature of the chamber is then lowered to a desired processing temperature.

By providing a separate pre-cleaning chamber, embodiments in accordance with the present invention increase throughput since the process chamber does not have to double as a pre-cleaning chamber and may thus be continuously employed for processing wafers. Further, by performing pre-cleaning functions at temperatures substantially lower than one thousand, one hundred and sixty degrees centigrade, embodiments in accordance with the present invention reduce the associated thermal budget. Of course, it should be noted that the pre-cleaning chamber is separate from the process chamber in present embodiments and is thus not used for film deposition. Therefore, the pre-cleaning chamber may be optimised for cleaning wafers.

After pre-cleaning, the mechanical arm inserts the wafer into reactor **10** through openings **14c** and **22a** and places the wafer in a radially-centred position with respect to susceptor **50** resting on pins **54.** In this position, wafer **52** is approximately 0.64 centimetres (quarter of an inch) above the surface of susceptor **50.** Recall that the temperature of susceptor **50** is approximately eight hundred degrees centigrade from previous process runs. Thus, the wafer should experience a symmetrical heating pattern emanating from susceptor **50.** In order to minimise slip, wafer **52** should be inserted into reactor **10** and into its appropriate position on pins **54** in less than approximately 1.5 seconds. Susceptor **50** is then raised so as to lift wafer **52** off pins **54**, as described earlier, thereby quickly bringing the temperature of water **52** to approximately eight hundred degrees centigrade. As housing **42** and susceptor **50** are elevated towards dish **32,** power levels applied to coils **44** and thus the RF energy emitted thereby are manipulated such that all portions of wafer **52** are brought to the reaction temperature in a uniform manner.

The dual-chamber structure of reactor **10** allows for superior performance over conventional CVD reactors that employ a single chamber which serves as both the pressure vessel and the reaction chamber. In such conventional CVD reactors, the chamber must be designed in such a manner so as to achieve not only a low pressure environment capable of withstanding the external atmospheric pressure but also an ideal flow of process gases. Since, as discussed earlier, the design considerations necessary to sustain a low pressure environment are not necessarily consistent with those necessary for optimizing process gas flow, the design of such single chamber CVD reactors undesirably requires compromising design considerations of both. That is, while a flat shaped chamber (i.e., one in which the dimension of the chamber perpendicular to the surface of the wafer is minimal) having a non-convoluted surface is desirable to optimize process gas flow, such flat structures are incapable of sustaining a low pressure environment without significant structural reinforcement. On the other hand, the ability to sustain low pressure environments compels a fuller globe-shaped chamber which, in turn, undesirably results in a wider flow channel for process gases. As noted above, a wide flow channel may adversely affect the process gas flow velocities and concentration gradients across the wafer. In sum, in addition to suffering from warm wall problems discussed above, the design of conventional single-chamber CVD reactors cannot be simultaneously optimized for both low pressure results and uniform process gas flow.

Thus, reactor 10 employs two separate chambers each of which is specifically designed for its intended purpose. The design of bell jar 16 is optimized to sustain a very low pressure therein without adversely influencing gas flow characteristics within reaction chamber 34a. Bell jar 16 is a domed-type structure as shown in Figures 1 and 2 which maximizes structural strength and thereby allows low pressures to be sustained therein. In preferred embodiments, bell jar 16 is approximately 10-20 mm thick and is capable of sustaining very low pressures, e.g. below 1E-8 Torr.

The ability to sustain low pressures improves the performance of reactor **10**. Pattern shift and distortion are greatly reduced at low pressures. Further, when processing a wafer at low pressures, materials may be deposited thereon at lower temperatures which, in turn, helps prevent wafer slip, ie, breaks along the lattice of crystalline silicon wafer, and lowers the associated thermal budget.

Reaction chamber **34a** is contained entirely within and is at the same pressure as the pressure vessel and thus does not have to withstand a large pressure difference between its interior and exterior. Accordingly, reaction chamber **34a** does not have to be of a domed shape but may rather be of a geometry which allows for optimum gas flow across wafer **52**. Accordingly, when wafer **52** is elevated to the processing position as described above and shown in *Figure 2*, reaction chamber **34a** is of a shape similar to that of a thin pancake and, by having a thin flow channel, advantageously allows for a maximum gas flow velocity through reaction chamber **34a**.

Applicants have determined that reaction chamber **34a** can be of a height of approximately 1.27 to 0.95 centimetres (one half to three-eighths of an inch), as measured between wafer **52** and dish **32,** in order to achieve a high process gas flow across wafer **52**. However, other embodiments may have a different height ranges for particular purposes. Reaction chambers having greater heights require a greater gas flow to maintain desirable gas velocity and may have slower deposition rates. On the other hand, reaction chambers having lower heights may cause depletion layer boundaries to merge, resulting in non-uniform depositions.

Isolating the process gases in reaction chamber **34a** from the pressure vessel results in certain advantages. First, process gases used in the formation of various layers on wafer 52 are prevented from entering volume 12 and, thus, do not deposit on the walls of bell jar 16. As a result, it is not necessary to frequently clean the inner walls of bell jar 16, thereby saving time and reducing operating expenses. Further, since process gases do not deposit on the walls of bell jar 16, heat transfer efficiency through the walls of bell jar 16 in those embodiments which employ heating lamps rather than induction coils 36 is not adversely affected during wafer processing.

Second, the isolation of reaction chamber 34a from the pressure vessel allows reactor 10 to form not only thin epitaxial films but also thick epitaxial films on wafer 52. As mentioned above, process gases undesirably deposit on the walls of conventional radiantly warm wall CVD chambers during wafer processing. When depositing films greater than 100 microns thick on a wafer, significant deposition can occur on the warm walls. Silicon deposited on the quartz walls can absorb heat generated from radiant heat sources. This absorbed heat further increases the temperature of the quartz walls and thereby increases the rate at which silicon deposits on the quartz walls. Deposition rates on the reactor walls therefore increase while the wafer temperature, and thus the local rate of deposition on the wafer, decreases. In contrast, with the present invention, the thickness of any deposition coating on the inner surface of dish 32 does not influence the heat transfer therethrough. Hence, even a 100 micron thick layer deposited on the inner surface of dish 32 would not significantly affect the delivery of heat energy through induction coils 36 to wafer 52 through dish 32.

Positioning wafer 52 within a black body cavity (reaction chamber 34a) during processing is also advantageous in allowing for more accurate temperature measurements of wafer 52. Since wafer 52 quickly reaches thermal equilibrium with the walls of reaction chamber 34a, the temperature of wafer 52 may be determined by measuring the temperature of the exterior of the walls of reaction chamber 34a. Recall that the dual-chamber design of reactor 10 prevents unwanted deposition of process gases on surfaces which form volume 12. Thus, unlike the emissivity of wafer 52, the emissivity of the exterior of the walls of reaction chamber 34a is predictable during processing of wafer 52. In this manner, the temperature of wafer 52 may be determined independently of its changing emissivity, thereby allowing the temperature of wafer 52 to be determined with increased precision. This is in marked contrast to those conventional CVD reactors that attempt to directly measure the temperature of wafer 52, which can change as the layer of material deposits on the wafer.

Further, the simple shape of chamber 34a, as compared to other reaction chambers commonly used in other CVD reactors, allows for a quick and easy cleaning of chamber 34a. Indeed, Applicants have found that chamber 34a may be cleaned in less than 30 seconds using HCl. In contrast, it typically takes as much as 3 minutes to clean the chamber of a typical radiantly heated CVD reactor.

Note that although described above and illustrated in the drawings as employing RF heating coils, reactor 10 may in other embodiments employ other heating systems such as a radiant heating system while still realizing the advantages described above.

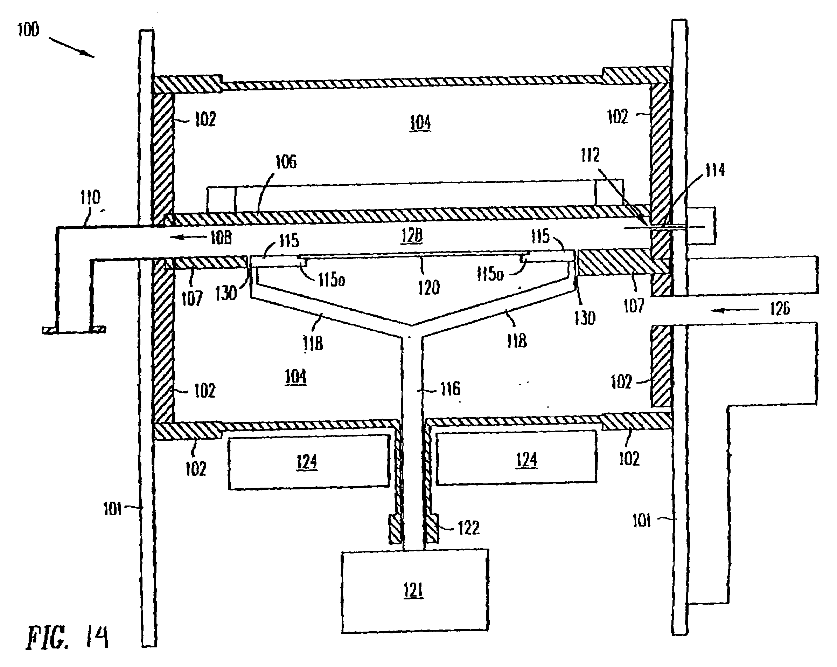

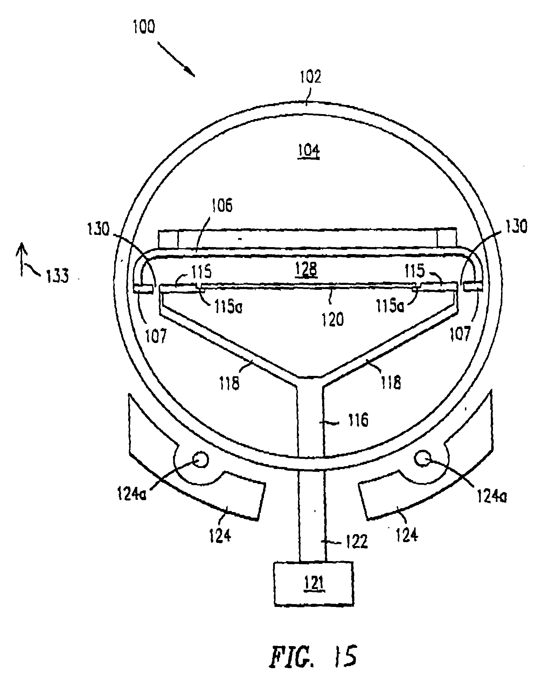

Another embodiment in accordance with the present invention is shown in Figures 14 and 15. Reactor 100 includes a stainless steel frame 101 (shown only in Figure 3 for simplicity) supporting a cylindrical clear quartz pressure vessel 102 that contains a low pressure environment 104. Within pressure environment 104 is positioned an inverted top plate 106 and a bottom plate 107 which is supported on a periphery thereof by body 102. Top plate 106 and bottom plate 107 are preferably either graphite or silicon carbide. Aligned openings 108 formed in respective vessel 102 and top plate 106 allow one or more exhaust tubes 110 to pass therethrough, while aligned openings 112 formed in respective body 102 and top plate 106 allow one or more process gas injection tubes 114 to pass therethrough.

A graphite support which includes a shaft 116 connected to three arms 118 is provided to position and rotate susceptor 115. A susceptor 115 preferably made of graphite is mounted onto arms 118 and supports a wafer 120. Susceptor 115 may have a recessed portion 115a and an open center, as shown in Figure 14, or may be of a construction similar to that of susceptor 50 shown in Figures 3A and 3B. In either embodiment, susceptor 115 properly centers a wafer 120 within reactor 100 and also minimizes variations in the transfer of heat to wafer 120. Shaft 116 passes through an opening in vessel 102 and is operatively coupled in a conventional manner to a drive motor 121 via a casing 122 affixed to vessel 102, as shown in Figure 15. Drive motor 121 may be of any well known suitable design capable of raising and lowering support 116 within vessel 102 and capable of rotating support 116 (and thus wafer 120) to speeds appropriate for CVD processing.

In one embodiment, a layer of quartz is provided on an inner surface of vessel 102 to insulate stainless steel frame 101 from heat energy emitted from lamp housings 124 positioned underneath vessel 102. In one embodiment, lamp housings 124 each include a plurality of arc-type argon lamps 124a. Lamps 124a do not have filaments and may thus be maintained in working condition more cheaply than can filament type lamps. A plurality of heat lamps (not shown) arranged in three independently controlled zones outside and about the periphery of vessel 102 in a well known manner indirectly heat wafer 120 via dish 106. These hear lamps arranged on the outer periphery of vessel 102, together with lamp housings 124, radiantly heat top plate 106, bottom plate 107, and susceptor 115 which, by approximating a black body cavity, heat wafer 120 in a uniform manner.

Wafer 120 is processed in reactor 100 as follows. Initially, support 116 is in a loading position (not shown) such that wafer 120 may be inserted into vessel 102 through an opening 126 formed in vessel 102 via a robotic arm (which is of a well known design and is thus not shown for simplicity). Drive motor 121 is operated so as to raise support 116 and wafer 120 into a processing position, as shown in Figure 15. When in the processing position, top plate 106, bottom plate 107, wafer 120, and susceptor 115 form within pressure vessel 102 a reaction chamber 128 which, as mentioned above, approximates a black body cavity.

During processing of wafer 120, process gases are injected into reaction chamber 128 through one or more intake tubes 114 (Figure 14) via suitable gas injection systems, such as the one described above or ones well known in the art. Reaction chamber 128, like reaction chamber 34a of reactor 10 (see Figures 1 and 2), has a narrow height dimension as defined by arrow 133 to ensure optimum flow of process gases within reaction chamber 128.

Power is applied to lamps 124a to indirectly heat wafer 120 to a desired reaction temperature. The black body cavity approximated by reaction chamber 128 allows for excellent temperature uniformity across the surface of wafer 120 using these lamps. In some embodiments, lamps 124a may be arranged into multiple independently controlled heating zones. In one embodiment, each of lamps 124a is rated at 150-200 kW so as to heat an area much larger than the surface area of wafer 120. In this manner, the entirety of wafer 120 will be within the "sweet spot" of the heated zone such that edge effects will be of minimum influence at the outer edge of wafer 120.

During processing, hydrogen gas or any other suitable gas is forced through spacing 130 into reaction chamber 128, using conventional means, to prevent any process gases from escaping reaction chamber 128 and flowing to areas underneath susceptor 115.

Note that reaction chamber 128 is entirely contained within, and separate from, volume 104 sustained by pressure vessel 102 such that process gases flowing within reaction chamber 128 during processing of wafer 120 will not come into contact with vessel 102. Thus, by providing separate reaction 128 and pressure 104 chambers, reactor 100 achieves advantages similar to those discussed above with respect to reactor 10. Of particular importance is that pressure vessel 102 and reaction chamber 128 may be independently designed to optimize their intended functions. Thus, vessel 102 may be optimized for strength to sustain a low pressure, while reaction chamber 128 may be designed to optimize the flow characteristics of process gases used to form layers on wafer 120. In this manner, reactor 100 achieves a superior performance over prior art reactors having a single chamber which must not only sustain low pressures but must also optimize gas flow characteristics. Further, process gases are prevented from contacting chamber wall 102 and thus do not deposit thereon. Preventing film deposition upon the walls of pressure vessel **102** results in savings in cleaning time, thereby increasing wafer throughput.

## Claims

1. A gas injection system for injecting one or more process gases into a reaction chamber **(34a)** within which a wafer **(52)** is processed, said gas injection system being **characterised by**:
one or more first slots or holes **(28d)** formed in a first portion of the bottom surface **(24)** of said reaction chamber; and
one or more second slots or holes (**31g**) formed in a second portion of the bottom surface **(24)** of said reaction chamber, said one or more second slots or holes being positioned intermediate said one or more first slots or holes and a side wall **(32)** of said reaction chamber;
wherein a first gas is injected into said reaction chamber in a direction toward said wafer **(52)** through said one or more second slots or holes and said one or more process gases are injected into said reaction chamber through said one or more first slots or holes, said first gas serving to re-direct said one or more process gases into a flow pattern substantially parallel to a top surface of said wafer (52).

2. The gas injection system of claim **1**, wherein said one or more first slots or holes (**28d**) and said one or more second slots or holes **(31g)** are formed on a same surface **(24).**

3. The gas injection system of claim **1**, further comprising a heating source **(26)** located adjacent said first slots or holes, wherein said one or more process gases are pre-heated by said heating source before said one or more process gases enter said reaction chamber.

4. The gas injection system of claim **1,** further comprising one or more diffuser plates (**28b**) located approximately perpendicular to said one or more first slots or holes (**28d**) wherein said one or more diffuser plates diffuses said one or more process gases before said one or more process gases enter said reaction chamber **(34a).**

5. The gas injection system of claim **4,** wherein said one or more diffuser plates **(28b)** are located below said one or more first slots or holes (**28d**).

6. The gas injection system of claim **4,** wherein said one or more diffuser plates **(28b)** each have a multiplicity of openings **(29).**

7. The gas injection system of claim **1,** wherein said one or more process gases are injected into said reaction chamber **(34a)** through each of two or more of said first slots or holes **(28d)** at a flow rate independent of the flow rate through the remaining two or more of said first slots or holes.

8. The gas injection system of claim **1,** wherein said first gas is injected into said reaction chamber through said each of said two or more of said second slots or holes **(31g)** at a flow rate independent of the flow rate through the remaining said two or more of said second slots or holes.

9. A method of injecting one or more process gases into a reaction chamber **(34a)** within which a wafer is processed, comprising the steps of:
injecting a first gas into said reaction chamber in a direction towards said wafer;
injecting said one or more process gases into said reaction chamber from a first bottom portion of said reaction chamber; and
re-directing said one or more process gases into a flow pattern substantially parallel to a top surface of said wafer with said first gas.

10. A method as claimed in claim **9,** which includes the further steps of:
forming one or more first slots or holes (**28d**) in a bottom surface of said reaction chamber;
forming one or more second slots or holes **(31g)** in another bottom surface of said reaction chamber, said one or more second slots or holes being positioned intermediate said one or more first slots or holes and a side wall (**32**) of said reaction chamber.

11. The method of claim **10,** wherein said one or more second slots or holes are formed on a same surface **(24)** as said one or more first slots or holes.

12. The method of claims **10** or **11,** further comprising the step of pre-heating **(26)** said one or more process gases before said one or more process gases enter said reaction chamber.

13. The method of claims **10, 11** or **12,** further comprising the step of diffusing **(28b)** said one or more process gases before said one or more process gases enter said reaction chamber.

14. The method of claims **10, 11, 12** or **13**, further comprising the step of forming one or more vertical third slots or holes (**28c**) connected to each of said one or more first slots or holes, wherein said one or more third slots or holes diffuses said one or more process gases before said one or more process gases enter said reaction chamber **(34a).**

15. The method of claim **14,** wherein said one or more third slots or holes **(28c)** are formed below each of said one or more first slots or holes **(28d).**

16. The method of any one of claims **10** to **15,** further comprising the step of adjusting a flow rate of said one or more process gases through each of two or more said first slots or holes (**28d**).

17. The method of any one of claims **10** to **16,** further comprising the step of adjusting a flow rate of said first gas through each of two or more said second slots or holes (**31g**).

18. The method of claim **9,** wherein the injecting said first gas is from a second bottom portion of said reaction chamber, said second bottom portion being located between said first bottom portion and a side wall (**32**) of said reaction chamber **(34a).**

## Patentansprüche

1. Gasinjektionssystem zum Injizieren eines oder mehrerer Verfahrensgase in eine Reaktionskammer (34a) innerhalb der ein Waver (52) bearbeitet wird, wobei das genannte Gasinjektionssystem charakterisiert wird durch:
einen oder mehrere erste Schlitze oder Löcher (28d), die in einem ersten Teil der Bodenfläche (24) der genannten Reaktionskammer gebildet sind; und
einen oder mehrere zweite Schlitze oder Löcher (31g), die in einem zweiten Teil der Bodenfläche (24) der genannten Reaktionskammer gebildet sind, wobei die genannten ein oder mehreren zweiten Schlitze oder Löcher zwischen den genannten ein oder mehreren ersten Schlitzen oder Löchern und einer Seitenwand (32) der genannten Reaktionskammer angeordnet sind;
wobei ein erstes Gas durch die genannten ein oder mehreren zweiten Schlitze oder Löcher in einer Richtung auf den Waver (52) in die genannte Reaktionskammer injiziert wird und die genannten ein oder mehreren Verfahrensgase durch die genannten ein oder mehreren ersten Schlitze oder Löcher in die genannte Reaktionskammer injiziert werden, wobei das erste Gas dazu dient, um die besagten einen oder mehreren Verfahrensgase in ein Strömungsmuster zurückzuführen, das im Wesentlichen parallel zu einer oberen Fläche des genannten Wavers (52) ist.

2. Das Gasinjektionssystem gemäß Anspruch 1,
wobei die genannten ein oder mehreren ersten Schlitze oder Löcher (28d) und die genannten ein oder mehreren zweiten Schlitze oder Löcher (31g) auf einer selben Fläche (24) gebildet sind.

3. Das Gasinjektionssystem gemäß Anspruch 1,
weiterhin umfassend eine Heizquelle (26), die benachbart zu den genannten ersten Schlitzen oder Löchern angeordnet ist, wobei die genannten ein oder mehreren Verfahrensgase durch die genannte Heizquelle vorgeheizt werden, bevor die genannten ein oder mehreren Verfahrensgase in die genannte Reaktionskammer eintreten.

4. Das Gasinjektionssystem gemäß Anspruch 1,
weiterhin umfassend ein oder mehrere Diffusorplatten (28b), die im Wesentlichen rechtwinklig zu den genannten ein oder mehreren ersten Schlitzen oder Löchern (28d) angeordnet sind, wobei die genannten ein oder mehreren Diffusorplatten (28b) die genannten ein oder mehreren Verfahrensgase verteilen, bevor die genannten ein oder mehreren Verfahrensgase in die genannte Reaktionskammer (34a) eintreten.

5. Das Gasinjektionssystem gemäß Anspruch 4,
wobei die genannten ein oder mehreren Diffusorplatten (28b) unterhalb der genannten ein oder mehreren ersten Schlitze oder Löcher (28d) angeordnet sind.

6. Das Gasinjektionssystem gemäß Anspruch 4,
wobei die genannten ein oder mehreren Diffusorplatten (28b) jede eine Vielzahl von Öffnungen (29) haben.

7. Das Gasinjektionssystem gemäß Anspruch 1,
wobei die genannten ein oder mehreren Verfahrensgase durch jede von zwei oder mehr der genannten ersten Schlitze oder Löcher (28d) bei einer Strömungsrate in die genannte Reaktionskammer (34a) injiziert werden, die unabhängig ist von der Strömungsrate durch die verbleibenden zwei oder mehr der genannten ersten Schlitze oder Löcher.

8. Das Gasinjektionssystem gemäß Anspruch 1,
wobei das genannte erste Gas durch jede der genannten zwei oder mehr der genannten zweiten Schlitze oder Löcher (31g) bei einer Strömungsrate in die genannte Reaktionskammer injiziert wird, die unabhängig ist von der Strömungsrate durch die verbleibenden genannten zwei oder mehr der genannten zweiten Schlitze oder Löcher.

9. Ein Verfahren zur Injektion eines oder mehrerer Verfahrensgase in eine Reaktionskammer (34a) in der ein Waver bearbeitet wird, enthaltend die Schritte:
Injektion eines ersten Gases in die genannte Reaktionskammer in einer Richtung auf den genannten Waver zu;
Injektion eines oder mehrerer Verfahrensgase in die genannte Reaktionskammer von einem ersten Bodenteil der genannten Reaktionskammer; und
Wiederausrichtung der genannten ein oder mehreren Verfahrensgase in ein Strömungsmuster, das im Wesentlichen parallel zu einer oberen Fläche des genannten Wavers ist, mit dem genannten ersten Gas.

10. Das Verfahren gemäß Anspruch 9,
das die weiteren Schritte umfasst:
Bildung eines oder mehrerer erster Schlitze oder Löcher (28d) in einer Bodenfläche der genannten Reaktionskammer;
Bildung eines oder mehrerer zweiter Schlitze oder Löcher (31g) in einer anderen Bodenfläche der genannten Reaktionskammer, wobei die genannten ein oder mehreren zweiten Schlitze oder Löcher zwischen den genannten ein oder mehreren ersten Schlitzen oder Löchern und einer Seitenwand (32) der genannten Reaktionskammer angeordnet sind.

11. Das Verfahren gemäß Anspruch 10,
wobei die genannten ein oder mehreren zweiten Schlitze oder Löcher auf der gleichen Fläche (24) gebildet sind wie die genannten ein oder mehreren ersten Schlitze oder Löcher.

12. Das Verfahren gemäß einem der Ansprüche 10 oder 11,
weiterhin umfassend den Schritt des Vorheizens (26) von den besagten ein oder mehreren Verfahrensgasen bevor die genannten ein oder mehreren Verfahrensgase in die genannte Reaktionskammer eintreten.

13. Das Verfahren gemäß den Ansprüchen 10, 11 oder 12,
weiterhin umfassend den Schritt, die genannten ein oder mehreren Verfahrensgase zu verteilen (28b), bevor die genannten ein oder mehreren Verfahrensgase in die genannte Reaktionskammer eintreten.

14. Das Verfahren gemäß der Ansprüche 10, 11, 12 oder 13,
weiterhin umfassend den Schritt, ein oder mehrere vertikale dritte Schlitze oder Löcher (28c) zu bilden, die mit jeder der genannten ein oder mehreren ersten Schlitzen oder Löcher verbunden sind, wobei die genannten ein oder mehreren dritten Schlitze oder Löcher die genannten ein oder mehreren Verfahrensgase verteilen, bevor die ein oder mehreren Verfahrensgase in die genannte Reaktionskammer (34a) eintreten.

15. Das Verfahren gemäß Anspruch 14,
wobei die genannten ein oder mehreren dritten Schlitze oder Löcher (28c) unterhalb jeder der genannten ein oder mehreren ersten Schlitze oder Löcher (28d) gebildet werden.

16. Das Verfahren gemäß einer der Ansprüche 10 bis 15,
weiterhin umfassend den Schritt, eine Strömungsrate der genannten ein oder mehreren Verfahrensgase durch jede von zwei oder mehr der genannten ersten Schlitze oder Löcher (28d) zu justieren.

17. Das Verfahren gemäß einer der Ansprüche 10 bis 16,
weiterhin umfassend den Schritt, eine Strömungsrate des genannten ersten Gases durch jede von zwei oder mehr der genannten zweiten Schlitze oder Löcher (31g) zu justieren.

18. Das Verfahren gemäß Anspruch 9,
wobei die Injektion des genannten ersten Gases von einem zweiten Bodenteil der genannten Reaktionskammer erfolgt, wobei der genannte zweite Bodenteil zwischen dem genannten ersten Bodenteil und einer Seitenwand (32) der genannten Reaktionskammer (34a) angeordnet ist.

## Revendications

1. Système d'injection de gaz pour injecter un ou plusieurs gaz de traitement dans une chambre (34a) de réaction à l'intérieur de laquelle une tranche (52) est traitée, le système d'injection de gaz étant **caractérisé par** :
un ou plusieurs premiers trous ou fentes (28d) formés dans une première partie de la surface (24) de fond de la chambre de réaction ; et
un ou plusieurs seconds trous ou fentes (31g) formés dans une seconde partie de la surface (24) de fond de la chambre de réaction, lesdits un ou plusieurs seconds trous ou fentes étant positionnés intermédiairement entre lesdits un ou plusieurs premiers trous ou fentes et une paroi (32) latérale de la chambre de réaction ;
un premier gaz étant injecté dans la chambre de réaction suivant une direction vers la tranche (52) en passant par ledit un ou plusieurs seconds trous ou fentes et ledit un ou plusieurs gaz de traitement sont injectés dans la chambre de réaction en passant par lesdits un ou plusieurs premiers trous ou fentes, le premier gaz servant à rediriger lesdits un ou plusieurs gaz de traitement suivant une configuration d'écoulement sensiblement parallèle à une surface supérieure de la tranche (52).

2. Système d'injection de gaz suivant la revendication 1, dans lequel lesdits un ou plusieurs premiers trous ou fentes (28d) et lesdits un ou plusieurs seconds trous ou fentes (31g) sont formés sur une même surface (24).

3. Système d'injection de gaz suivant la revendication 1, comportant en outre une source (26) de chauffage située adjacente auxdits premiers trous ou fentes, lesdits un ou plusieurs gaz de traitement étant préchauffés par la source de chauffage avant que lesdits un ou plusieurs gaz de traitement ne pénètrent dans la chambre de réaction.

4. Système d'injection de gaz suivant la revendication 1, comportant en outre une ou plusieurs plaques (28b) de diffusion situées approximativement perpendiculairement auxdits un ou plusieurs premiers trous ou fentes (28d), lesdites une ou plusieurs plaques de diffusion diffusant lesdits un ou plusieurs gaz de traitement avant que lesdits un ou plusieurs gaz de traitement ne pénètrent dans la chambre (34a) de réaction.

5. Système d'injection de gaz suivant la revendication 4, dans lequel lesdites une ou plusieurs plaques (28b) de diffusion se trouvent en-dessous desdits un ou plusieurs premiers trous ou fentes (28d).

6. Système d'injection de gaz suivant la revendication 4, dans lequel lesdites une ou plusieurs plaques (28b) de diffusion ont chacune une multiplicité d'ouvertures (29).

7. Système d'injection de gaz suivant la revendication 1, dans lequel lesdits un ou plusieurs gaz de traitement sont injectés dans la chambre (34a) de réaction en passant par chacun de deux ou plus des premiers trous ou fentes (28d) à une vitesse d'écoulement indépendante de la vitesse d'écoulement de passage par les premiers trous ou fentes restants.

8. Système d'injection de gaz suivant la revendication 1, dans lequel le premier gaz est injecté dans la chambre de réaction en passant par lesdits chacun des deux ou plusieurs des seconds trous ou fentes (31g) à une vitesse d'écoulement indépendante de la vitesse d'écoulement de passage par lesdits deux ou plusieurs des seconds trous ou fentes restants.

9. Procédé d'injection de un ou plusieurs gaz de traitement dans une chambre (34a) de réaction à l'intérieur de laquelle est traitée une tranche, comportant les étapes qui consistent à :
injecter un premier gaz dans la chambre de réaction suivant une direction vers la tranche ;
injecter lesdits un ou plusieurs gaz de traitement dans la chambre de réaction à partir d'une première partie de fond de la chambre de réaction ; et
rediriger lesdits un ou plusieurs gaz de traitement suivant une configuration d'écoulement sensiblement parallèle à une surface supérieure de la tranche avec le premier gaz.

10. Procédé suivant la revendication 9, qui comporte en outre les étapes qui consistent à :
former un ou plusieurs premiers trous ou fentes (28d) dans une surface de fond de la chambre de réaction ;
former un ou plusieurs seconds trous ou fentes (31g) dans une autre surface de fond de la chambre de réaction, lesdits un ou plusieurs seconds trous ou fentes étant positionnés intermédiairement entre lesdits un ou plusieurs premiers trous ou fentes et une paroi (32) latérale de la chambre de réaction.

11. Procédé suivant la revendication 10, dans lequel lesdits un ou plusieurs seconds trous ou fentes sont formés sur une même surface (24) que celle-ci sont formés lesdits un ou plusieurs premiers trous ou fentes.

12. Procédé suivant la revendication 10 ou 11, comportant en outre l'étape qui consiste à préchauffer (26) lesdits un ou plusieurs gaz de traitement avant que lesdits un ou plusieurs gaz de traitement ne pénètrent dans la chambre de réaction.

13. Procédé suivant la revendication 10, 11 ou 12, comportant en outre l'étape qui consiste à diffuser (28b) lesdits un où plusieurs gaz de traitement avant que lesdits un ou plusieurs gaz de traitement ne pénètrent dans la chambre de réaction.

14. Procédé suivant la revendication 10, 11, 12 ou 13, comportant en outre l'étape qui consiste à former un ou plusieurs troisièmes trous ou fentes verticaux (28c) reliés à chacun desdits un ou plusieurs premiers trous ou fentes, lesdits un ou plusieurs troisièmes trous ou fentes diffusant lesdits un ou plusieurs gaz de traitement avant que lesdits un ou plusieurs gaz de traitement ne pénètrent dans la chambre (34a) de réaction.

15. Procédé suivant la revendication 14, dans lequel lesdits un ou plusieurs troisièmes trous ou fentes (28c) sont formés en-dessous de chacun desdits un ou plusieurs premiers trous ou fentes (28d).

16. Procédé suivant l'une quelconque des revendications 10 à 15, comportant en outre l'étape qui consiste à ajuster une vitesse d'écoulement desdits un ou plusieurs gaz de traitement qui passent par chacun de deux ou plus des premiers trous ou fentes (28d).

17. Procédé suivant l'une quelconque des revendications 10 à 16, comportant en outre l'étape qui consiste à ajuster une vitesse d'écoulement du premier gaz passant par chacun de deux ou plus des seconds trous ou fentes (31g).

18. Procédé suivant la revendication 9, dans lequel l'étape d'injection du premier gaz se fait à partir d'une seconde partie de fond de la chambre de réaction, la seconde partie de fond se trouvant entre la première partie de fond et une paroi (32) latérale de la chambre (34a) de réaction.
